# EUROPEAN PATENT APPLICATION

(11) **EP 3 740 052 A1**
(43) Date of publication of application: **18.11.2020**
(21) Application number: 19174265.9
(22) Date of filing: 14.05.2019
(51) Int. Cl.: H05K 7/20

(54) **HATCH ARRANGEMENT**

(71) Applicant: ABB Schweiz AG, 5400 Baden (CH)
(72) Inventor: Keränen, Ilmari, 00380 Helsinki (FI); Keränen, Lauri, 68100 Himanka (FI); Heiliö, Jussi, 00380 Helsinki (FI)
(74) Representative: Kolster Oy Ab

(57) **Abstract**

A hatch arrangement for an airflow hole of a cabinet, comprising an openable hatch coupled with the cabinet, wherein the hatch is configured to cover the airflow hole in a closed position. A sealing member configured to be compressed around the airflow hole between the cabinet and the hatch when the hatch is in the closed position. One or more magnetic holding members configured to provide a force for holding the hatch in the closed position and ensure a compression of the sealing member between the cabinet and the hatch when the hatch is in the closed position.

## Description

### FIELD OF THE INVENTION

The invention relates to a hatch arrangement for an airflow hole of a cabinet used for electronic equipment.

### BACKGROUND OF THE INVENTION

A cabinet is often used with sensitive electronic equipment in outdoor installations. The sensitive electronic equipment is placed into the cabinet that usually is a closed structure. There is, however, one drawback when placing the electronic equipment in the cabinet having the closed structure. The electronic equipment create excess heat, which causes a risk of overheating within the cabinet. Therefore, there is a need for cooling the internal space of the cabinet, in order to eliminate any risks of fire or any risks that components of the electrical equipment would be damaged due to excess heat.

The cooling of the cabinet is usually carried out by fans, which provide an airflow for cooling the electronic equipment in the cabinet. The cabinet normally comprises airflow holes, like an inlet and outlet, for taking the cooling air into the cabinet and removing after cooling. The fans are normally inside the cabinet between the inlet and outlet. The airflow holes may be problematic for the closed structure of the cabinet, because the airflow holes should be covered tightly when the fans are not in use and opened easily when the fans are used for cooling.

Current solutions for covering the airflow hole of the cabinet may not be effective and hence, there is a need for a sophisticated hatch solution for covering the airflow hole of cabinet.

### BRIEF DESCRIPTION OF THE INVENTION

The invention is defined by the independent claims.

Embodiments of the invention are defined in the dependent claims.

### BRIEF DESCRIPTION OF THE DRAWINGS

In the following the invention will be described in greater detail by means of preferred embodiments with reference to the attached drawings, in which
Figures 1A and 1B illustrate a hatch arrangement applied in a cabinet according to embodiments;
Figures 2A, 2B and 2C illustrate the hatch arrangement according to embodiments;
Figures 3A and 3B illustrate the hatch arrangement applied in an electronic system according to embodiments;

### DETAILED DESCRIPTION OF THE INVENTION

The following embodiments are only examples. Although the specification may refer to "an" embodiment in several locations, this does not necessarily mean that each such reference is to the same embodiment(s), or that the feature only applies to a single embodiment. Single features of different embodiments may also be combined to provide other embodiments. Furthermore, words "comprising" and "including" should be understood as not limiting the described embodiments to consist of only those features that have been mentioned and such embodiments may contain also features/structures that have not been specifically mentioned.

As described in Background, the electronic equipment inside the cabinet provides heat and hence, a cooling system is needed. The cooling system of the cabinet is often carried out by the one or more fans such that the fans take cooling air into the cabinet thought a first airflow hole, which is the inlet, and blow out the airflow after cooling through a second airflow hole, which is the outlet. The airflow hole should be covered properly when the fans are not in use to prevent ingress of dust and moisture into the cabinet. Still, the covered airflow hole should also be opened easily when the fans are turned on and are in use.

A solution according to invention provides the sophisticated solution for closing and opening the airflow hole of the cabinet. The solution according to the invention may be applied particularly with the outlet of the cooling airflow but it may also be suitable for any other airflow holes like, for example, for the inlet of the airflow.

In an embodiment, a hatch arrangement for an airflow hole of a cabinet, comprising: an openable hatch coupled with the cabinet, wherein the hatch is configured to cover the airflow hole in a closed position; a sealing member configured to be compressed around the airflow hole between the cabinet and the hatch when the hatch is in the closed position; and one or more magnetic holding members configured to provide a force for holding the hatch in the closed position and ensure a compression of the sealing member between the cabinet and the hatch when the hatch is in the closed position.

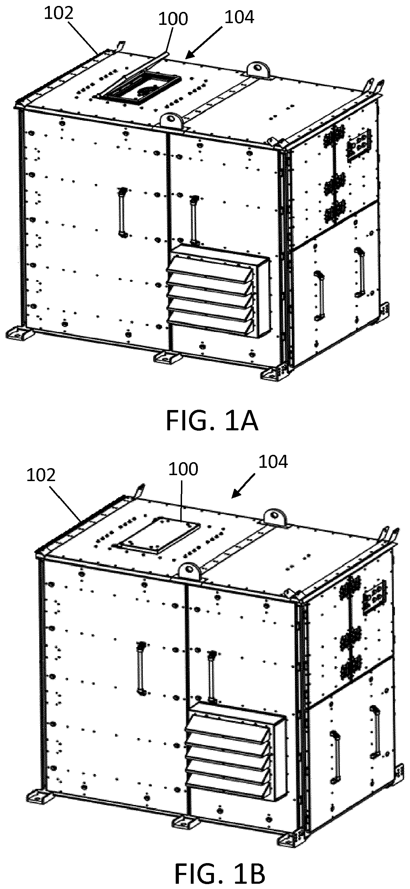

Figure 1A illustrates the cabinet 102 with the airflow hole 104 wherein the hatch arrangement 100 may be used. The airflow hole 104 may be an opening in a structure of the cabinet 102, in other words, the airflow hole 104 may be defined by the structure of the cabinet 102. There may be one or more airflow holes 104 in different points of the cabinet 102. The airflow hole 104 may be the inlet or outlet for the cooling airflow, in other words, the airflow may be guided through the airflow hole 104 into the cabinet 102 (inlet) or out of the cabinet 102 (outlet). The hatch arrangement 100 in an open position is also illustrated in Figure 1A.

In an embodiment, the airflow hole 104 is the outlet for the cooling airflow and is placed on the top of the cabinet 102 as illustrated in Figure 1A. In other words, the airflow hole is used to blow the cooling airflow out of the cabinet after cooling. The airflow hole may also be placed in some other place of the cabinet like, for example, in a side. In some case, a first airflow hole may be in the side and a second airflow hole on the top of the cabinet, wherein the first airflow hole may be the inlet and the second the outlet, for example.

In an embodiment, the hatch arrangement is positioned such that in the closed position it covers the airflow hole. In other words, the hatch arrangement closes the airflow hole in the closed position. Referring to Figure 1B, the hatch arrangement 100 is in the closed position and the airflow hole 104 is covered by the hatch. The hatch arrangement 100 may prevent, at least partly, a passage of the airflow through the airflow hole 104 in the closed position.

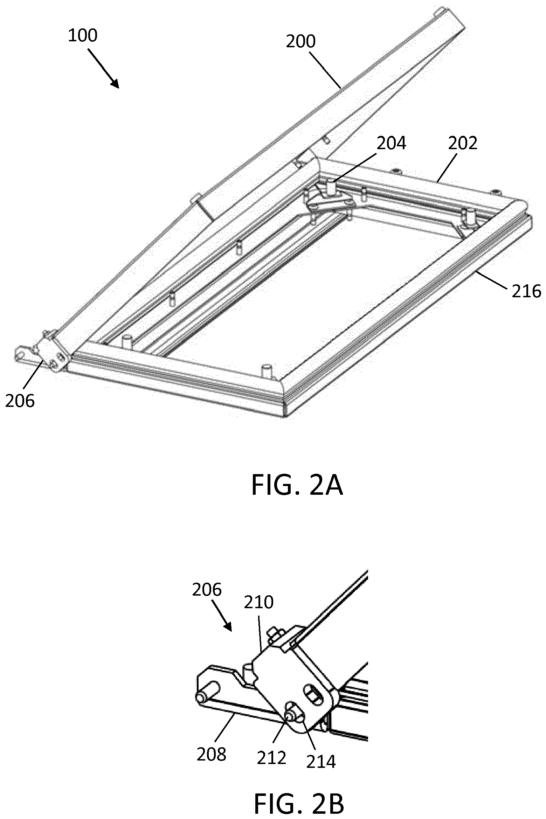

Referring to Figure 2A, wherein the hatch arrangement 100 is illustrated according to an embodiment. The hatch arrangement 100 comprises the openable hatch 200, the sealing member 202 and the one or more magnetic holding members 204. One or more hinges 206 may be used to couple the openable hatch with the cabinet, for example. The hatch 200 may be made of a sheet metal, for example, an aluminium sheet. A thickness of the sheet used in the hatch 200 may vary according to the needs. It may be, for example, 1mm to achieve a light structure. In addition, any other material like, for example, a plastic may be used in the hatch 200.

The one or more hinges may be placed on the one side of the hatch such that the hinges enable turning of the hatch in relation to the cabinet. In other words, the hinges make possible to couple the hatch pivotally with the cabinet. Referring to Figures 1A and 1B wherein the turning of the hatch 200 in relation to the cabinet 102 is illustrated. In Figure 1A, the hatch 200 is in the open position and in Figure 1B in the closed position, wherein the hinges 206 are placed on the one side of the hatch 200 such that the hatch 200 pivotally opens and closes in relation to the cabinet 102. The one or more hinges 206 may be made of the metal and/or plastic and/or any other suitable material.

In an embodiment, the hinges comprise a clearance for allowing a movement of the hatch in relation to the cabinet, in addition to the rotational movement. For example, the hatch may move, in addition to the rotational movement, away and towards from/to the surface of the cabinet wherein the hatch arrangement is assembled. Referring to Figure 2B, the hinge 206 may comprise a first part 208 and a second part 210, wherein the first part 208 may be coupled with the cabinet 102 and the second part 210 with the hatch 200. The first part 208 may comprise a pin 212 and the second part 210 may comprise an oval hole 214, wherein the pin 208 is configured to be set inside the oval hole 214. The oval hole 214 of the second part 210 of the hinge 206 is coupled with the hatch 200 allowing the hatch 200 move at least in a longitudinal direction of the oval hole 214, in addition to the rotational movement. The movement in the longitudinal direction of the oval hole 214 enables the movement of the hatch 200 such that the hatch 200 may be set to a proper position in relation to the one or more magnetic holding members 204 and the sealing member 202 when closing the hatch 200. In other words, the movement may help to close the hatch 200 and achieve uniform compression of the sealing member 202 when closing the hatch 200.

The sealing member is configured to be compressed between the hatch and cabinet in the closed position of the hatch. The sealing member seals an interface between the hatch and the cabinet and may prevent, at least partly, the air passage through the airflow hole when the hatch is in the closed position. The sealing member is configured to be positioned around the airflow hole. Hence, when the hatch is in the closed position, the sealing member is between the hatch and cabinet and creates the sealed interface between them, which may prevent the airflow passage thought the airflow hole. Mechanical features may be used for fastening the sealing member. The sealing member may comprise a groove and a part, where the sealing element is fastened, may comprise a protrusion configured to be set into the groove. Hence, setting the protrusion into the groove locks the sealing member on its place. In addition, the sealing member may be fastened by a chemical or mechanical fastening like, for example, a glue or a screw. In some embodiment, all mentioned solutions may be applied.

The dimensions of the sealing member may vary according to the needs. For example, a size of the airflow hole may affect a size and a shape of the sealing member and a gap between the hatch and the cabinet may affect a height of the sealing member. In addition, a desired compression of the sealing member, a type of the sealing member and a tightness of the sealing interface may affect the dimensions as well as. The desired compression of the sealing member may be, for example, 10-30% of the height of the sealing member. The tightness of the sealing interface means how tight the interface is when the sealing member is compressed.

The one or more magnetic holding members are configured to hold the hatch closed to ensure the proper compression of the sealing member when the hatch is in the closed position. As described earlier, the sealing member is configure to be compressed between the hatch and the cabinet in the closed position of the hatch. The one or more magnetic holding members may hold the hatch closed such that the desired compression of the sealing member may be achieved hence, also the desired tightness level of the sealing interface between the hatch and cabinet may be achieved.

The one or more magnetic holding members have a magnetic field providing a magnetic force for holding the hatch closed. The force attracts the hatch to the closed position when the hatch is in an influence area of the force of the magnetic holding member, in other words, nearby the magnetic holding member. In an embodiment, the magnetic holding member may comprise a first part and a second part, which are configured to be coupled together by the magnetic force. The first and the second parts may positioned such that they are adjacent to each other when the hatch is in the closed position. The first part may be coupled, for example, with the cabinet and the second part with the hatch, wherein the magnetic force pulls the parts together when they are in the influence area of the magnetic force. Hence, the magnetic force may attract also the hatch to the closed position. The hatch is openable from the closed position when a force, which is an opposite for the holding force of the magnetic holding members and is also greater that the holding force, is directed to the hatch.

The hatch arrangement according to the invention provide a simple and an effective solution for closing and opening the airflow hole of the cabinet by using the magnetic holding members and also to hold the hatch in the closed position.

In an embodiment, the hatch arrangement further comprises a collar 216 around the airflow hole 104 coupled with the cabinet 102. The collar 216 is illustrated in Figure 2A. The collar 216 may be a continuous structure placed around the airflow hole 104 of the cabinet 102. In an embodiment, the sealing member 202 is coupled with the collar 216. Referring to Figure 2A, the sealing member 202 may be placed on the top of the collar 216, wherein the collar 216 rises the sealing member 202 up from the surface of the cabinet 102. Hence, the collar 216 may be a pedestal for the sealing member 202. In an embodiment, the collar 216 may also be coupled with the hatch 200.

The collar may be made of the sheet metal or it may also be an extrusion profile, for example. A cross section of the collar may be, for example, substantially U-shaped. The collar may be formed, for example, from four U-shaped pieces connected together by welding from ends forming substantially a rectangular shape. The collar may be coupled with the cabinet from a first branch of the U-shaped profile and the sealing element may be coupled to a second branch. The sealing member may be coupled with the collar, for example, by the mechanical features as described earlier. Then, for example, the second branch may be the protrusion that goes into the groove of the sealing member. In an embodiment, there is a sealing member also between the cabinet and collar for sealing an interface between them.

In an embodiment, the collar is a part of the cabinet, in other words, the collar is an integral part of the cabinet around the airflow hole. Hence, the collar may be made of the same material like the surface of the cabinet where the airflow hole is.

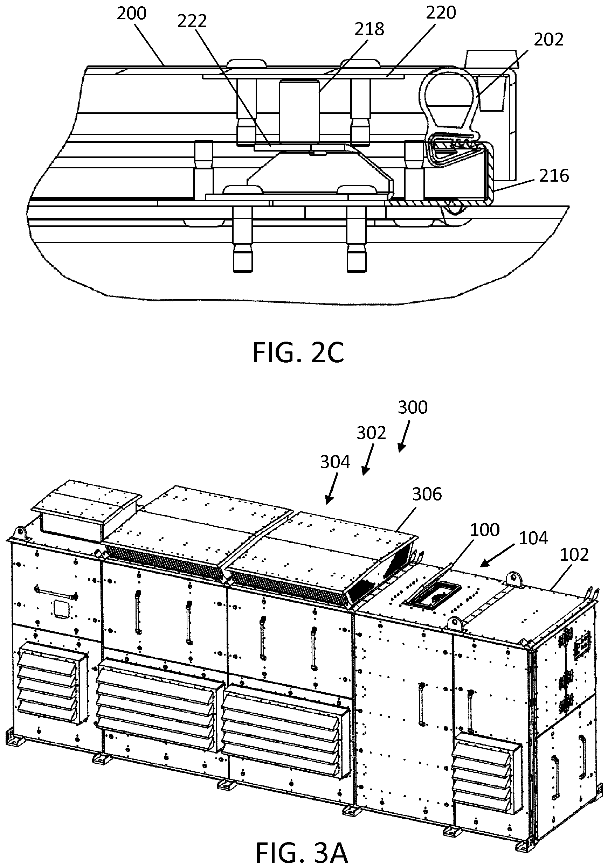

In an embodiment, the one or more magnetic holding members 204 comprise a magnet 218 and a magnetic responsive part 220. Referring to Figure 2C, wherein the hatch arrangement 100 is illustrated in the closed position. As described earlier, the magnetic holding member 204 may comprise the first part and the second part, wherein the first part may be the magnet 218 and the second part the magnetic responsive part 220. The magnetic responsive part 220 means that the part comprises a material which is magnetically active and attaches to the magnet 218 when it is in the influence area of the magnet 218. The magnetic responsive part 220 may be made of a magnetic steel, for example. Hence, the first part of the holding member 204 may be the magnet 218 and the second part the magnetically responsive part 220, wherein the magnet 218 attracts the magnetically responsive part 220, when the magnetically responsive part 220 is in the influence area of the magnet 218.

In an embodiment, a pair of magnets, that can be connected together, are used. In other words, the magnets are positioned such that the magnetic force connects the pair together when the magnets are in the influence area of the magnetic field.

Figure 2C illustrates an embodiment, wherein the magnet comprises a pedestal 222 coupled with the magnet 218. The pedestal 222 may help to set the magnet 218 to the right position in relations to the magnetic responsive part 220 and hence, the magnetic holding member 204 may be adjustable. The pedestal 218 may comprise a pin with an external thread and the magnet 218 an internal thread, wherein the pedestal and magnet may be connected together with the treads. The pedestal with the magnet may be coupled with the cabinet 102, the hatch 200 and/or the collar 216. The pedestal may be made of the sheet metal and/or plastic, for example.

In an embodiment, the magnet 218 is coupled with the cabinet 102 and/or the collar 216 and the magnetic responsive part 220 is coupled with the hatch 200. This embodiment is illustrated in Figure 2C. In one example, the magnet 218 is coupled with the cabinet 102 and the magnetic responsive part with the hatch 200. In another example, the magnet 218 is coupled with the collar 216 and the magnetic responsive part with the hatch 200. It is also possible, when a plurality of magnets 218 and magnetic responsive parts 220 are used, that some of the magnets 218 may be coupled with the cabinet 102 and some with the collar 216. The magnet 218 may be placed directly on the surface of the cabinet 102 and/or collar 220, or there may be used, for example, the pedestal 222 with the magnet 218. The magnet 218 and the magnetic responsive part 220 are configured to meet each other in the closed position of the hatch 200 when the force of the magnet 218 attracts the magnetic responsive part 220 and hold the hatch 200 closed. In an embodiment, the magnet 218 is coupled with the hatch 200 and the magnetic responsive part is coupled with the cabinet 102 and/or collar 216.

In an embodiment, the magnet comprises a permanent magnet. The permanent magnet refers to the magnet that may not be controllable. In the other words, the magnet is permanently magnetic and the magnetic force may not be adjusted. The force of the magnet may vary between the different permanent magnets and a selection of the permanent magnet is done based on the force needed for holding the hatch closed.

In an embodiment, the magnet comprises an electromagnet. The electromagnet refers to the magnet that may be controlled by an electric current. The electromagnet may be carried out by a coil of wire, wherein the coil is magnetic when the electric current passes through it, and stops being magnetic when the current stops. Hence, the magnetic force of the electromagnet may be controlled and adjusted according to the needs. For example, when the hatch is in the closed position, the electromagnets are magnetic and when the hatch is going to be opened, the force of the magnetic may be reduced or stopped for opening the hatch. Controlling of the electromagnet may be carried out with a controlling unit. The controlling unit may be a separate module, a part of the hatch arrangement or a part of electronic equipment placed inside the cabinet. The controlling unit may be coupled with one or more cooling fans of the cabinet and/or a controlling unit of the cooling fans. The controlling unit may comprise a circuitry capable to detect the positions of the hatch and may also be capable detect when the position of the hatch should be changed, for example, when the hatch should be opened. For example, if the hatch is in the closed position and should be opened to let airflow out of the cabinet, the control unit may reduce or stop magnetic force of the magnet(s) enabling the opening of the hatch. In an embodiment, there may be used one or more sensors for detecting a different position of the hatch.

In an embodiment, the magnets used in the one or more magnetic holding members may comprise the permanent magnets and electromagnets.

In an embodiment, the sealing member and the one or more magnetic holding members are integrated together such that the magnet is in the sealing member. The sealing member may comprise, for example, a magnet strip, wherein the magnet strip may be integrated into the sealing member and hence, the sealing member may be magnetic and separate magnet(s) may not be used. For example, the sealing member may be magnetic and the hatch may comprise a magnetic responsive material, wherein the magnetic sealing member attracts the magnetic responsive part. The attraction of the magnetic sealing member holds the hatch in the closed position. The magnetic sealing member may also be in the hatch and the magnetic responsive part in the cabinet and/or collar. In an embodiment, both the magnetic sealing member and the separate magnet(s) may be used.

In an embodiment, a shape of the hatch is substantially a rectangular, wherein the one or more magnetic holding members are substantially at each corner area of the hatch in the closed position of the hatch. Referring to figure 2A, wherein the four holding members 204 are positioned such that they are at the each corner area of the rectangle shaped hatch 200 when the hatch 200 is in the closed position. When the magnetic holding members 204 are positioned nearby the each corner of the hatch 200, they are apart from each other providing the uniform holding force around the hatch 200 in the closed position of the hatch 200. The uniform holding force around the hatch 200 enables the uniform compression of the sealing member 202 and hence, may make the sealing interface tight. In an embodiment, the one or more magnetic holding members 202 are positioned nearby side edges of the hatch 200 uniformly. Then the shape of the hatch 200 may be something else that the substantially rectangular. The shape may be, for example, a circle such that there are no corners in the hatch 200.

In an embodiment, the sealing member comprises a polymer gasket, wherein the polymer gasket is configured to form a continuous shape around the airflow hole and a sealing interface between the hatch and the cabinet. The continuous shape means that the gasket circulates the airflow hole forming continuous profile for enabling the tight sealing interface. Referring to Figure 2A, wherein a shape of the airflow hole 104 is substantially a rectangular and the gasket has substantially the same shape. The gasket covers the airflow hole 104 from each side forming the continuous shape around the airflow hole 104. The gasket may be made of four pieces of the gasket such that the pieces are connected together from ends forming the rectangular shape. The ends of the gaskets, in other words corners, may be, for example, vulcanized together. In some other embodiment, the gasket may be made of one piece of the gasket such that ends are coupled together, for example, by the vulcanizing. A structure of the polymer gasket may be hollow and it may comprise a metallic stiffener inside, for example, for coupling the gasket with its counterpart. As described earlier, the sealing member 202 may have the groove for coupling the gasket with the cabinet 102 or collar 216. The groove may be reinforced by the metallic stiffener to achieve a better coupling performance.

In an embodiment, the sealing interface is configured to prevent at least partly ingress of dust and/or ingress of moisture into the cabinet via the airflow hole when the hatch is in the closed position. The cabinet may be used in outdoor conditions and it may be sealed against dust and moisture to protect the electronic equipment inside the cabinet. Hence, the sealing member between the hatch and the cabinet is configured to create the tight interface to prevent, at least partly, the ingress of dust and moisture into the cabinet.

An IP-classification (International Protection Marking or Ingress Protection Marking) according to IEC (International Electrotechnical Commission) standard 60529 is used to classify a protection level of outdoor products, like the outdoor cabinets. The IP-classification code consist of letters IP and two numbers, wherein the first number indicates a protection level against the ingress of hazardous parts and the second number indicates the protection level against the ingress of water. In an embodiment, the hatch arrangement is configured to achieve at least the protection level according to IP55 classification in the closed position when assembled in the cabinet.

In an embodiment, the one or more magnetic holding members are configured to stay inside the sealing interface when the hatch is in the closed position. As described earlier, the sealing member may be the continuous profile around the airflow hole forming the sealing interface between the hatch and the cabinet. The one or more holding members may be positioned such that they are inside the continuous profile of the sealing member. Referring to Figure 2A, wherein the shape of the sealing member 202 is the rectangular and the one or more magnetic holding members 204 are inside the rectangular shape. Then the one or more magnetic holding members 204 may be inside the sealing interface when the hatch 200 is in the closed position. Hence, the one or more magnetic holding members 204 may be protected against dust and moisture when the hatch 200 is in the closed position.

In one embodiment, the sealing member is coupled with the cabinet. The sealing member may be coupled with the surface of the cabinet around the airflow hole. Then the hatch is set against the gasket when closed and the sealing member is compressed between the cabinet and hatch. In another embodiment, the sealing member is coupled with the hatch. The sealing member may be coupled with the hatch such that the sealing member is positioned around the airflow hole in the closed position of the hatch. Then the sealing member moves with the hatch and is set against the surface of the cabinet or collar when the hatch is closed and the sealing member compresses between the cabinet or collar and the hatch. These embodiments are not illustrated in Figures.

Figure 3A illustrates an embodiment, wherein an electronic system 300 comprises an electronic equipment 302 within the cabinet 102, wherein the cabinet comprises an airflow hole 104, and wherein the cabinet further comprises the hatch arrangement 100 according to claims 1-13.

In an embodiment, the electronic equipment in the cabinet comprises one or more fans configured to provide a cooling airflow that is guided through the airflow hole of the cabinet. The cooling airflow, provided by the one or more fans, is configured to release holding of the closed hatch, when a force of the cooling airflow exceeds the force of one or more holding members of the hatch arrangement, and open the hatch.

In an embodiment, the electronic equipment comprises a solar inverter used for converting a direct current (DC) generated by solar modules into an alternating current (AC).

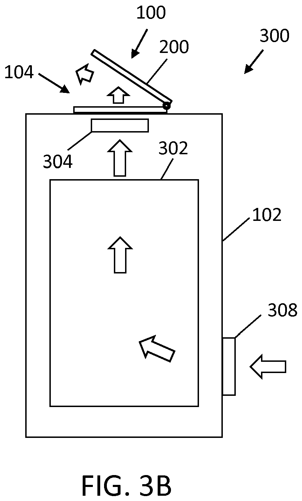

Referring to Figure 3B, wherein the electronic equipment 302 within the cabinet 102 comprise one or more fans 304 configured to suck the cooling air through the inlet hole 308 of the cabinet 102 and guide the cooling airflow through the electronic equipment 302 to the airflow hole 104, in this case outlet hole, and out of the cabinet 102. Arrows illustrate a route of the airflow. The hatch arrangement 100 is assembled in the cabinet 102 covering the airflow hole 104. When the one or more fans 304 are not in use the hatch 200 is in the closed position, wherein the one or more magnetic holding members 204 hold the hatch in the closed position. When the fans 304 are turned on, the hatch 200 must be opened to blow the cooling airflow of out of the cabinet 102 through the airflow hole 104. The one or more fans 304 are configured to provide the airflow for opening the closed hatch 200 when the force of the airflow, in other words an air pressure, exceeds the holding force of the one or more magnetic holding members 204. In other words, turning on the one or more fans 304 creates the airflow, which is pointed to the hatch 200. The one or more fans 304 may be nearby the airflow hole 104. The airflow provides an opposed force for the holding force of the one or more magnetic holding members 204, and when the force of the airflow exceeds the force of the one or more magnetic holding members 204 the hatch 200 opens.

In an embodiment, the inlet hole may further comprise one or more filters for filtering the air sucked into the cabinet.

In an embodiment, the airflow, used for opening the closed hatch, may be greater than the airflow needed for cooling the electronic equipment inside the cabinet. Hence, a rotation speed of the fans may be higher for a while at first to achieve the force of the airflow that is bigger than the holding force of the one or more magnetic holding members, in other words, the force of the airflow exceeds the holding force of the one or more holding members. When the hatch is open, the rotation speed of the fans may be set to a level, which is actually needed for cooling of the electronic equipment like the inverter. Turning off the fans stops the airflow and the hatch is closed by gravity and the attraction of the magnetic holding members.

While the hatch is in the closed position, hold by the one or more magnetic holding members and supported by the sealing member, opening of the hatch may be carried out such that the rotation speed of the fans is set to a predefined first rotation speed reference level by a controller. Then the fans provide a sufficient combined air pressure against the inner surface of the hatch, to defeat the holding force of the one or more holding members combined with the gravitational force of the hatch. The air pressure causing the hatch to lift from the surface of the sealing member. The controller may maintain the fan speed reference for a predetermined time, after which the controller changes the rotation speed reference level of the fans to a second level, which may correspond to the level of cooling needed by the cabinet. In some cases, the second fan rotation speed reference level is smaller than the first fan rotation speed reference level. In addition, if a plurality of the fans are used, the rotation speed of the individual fan may differ from the other fans. In other words, the rotation speed of the every fan may be set individ ually.

In an embodiment, the one or more holding members comprises the electromagnet. The holding force of the electromagnet may be reduced when opening the hatch by the airflow of the one or more fans. In an example, the electromagnet is turned off that stops the holding force of the electromagnet and enables opening of the hatch. Then the rotation speed of the fans may not be raised for achieving the greater force of the airflow for opening the hatch. In other words, when the electromagnet is turned off, the hatch is hold in the closed position by gravity and is then easy to open by the airflow. When the fans are turned off and the hatch should be closed, the electromagnet is activated again to get the attraction and the holding force for the hatch. Controlling of the electromagnets may be performed by the controlling unit of the one or more fans or it may be a separate unit within the cabinet, for example.

In an embodiment, when the hatch is closed and should be opened, the rotation speed of the fans is set to the level, wherein the air pressure against the hatch is big enough for opening the hatch and the position of hatch is monitored, for example, by one or more sensors. The sensor may detect when the hatch is opened by the air pressure, and after the detection, the rotation speed of the fans is set to the level that is used for cooling. For example, the controller may set the rotation speed of the fans to the first level which is high enough for opening the hatch and when the sensor detects that the hatch is open, the controller sets the rotation speed to the second level which is used for cooling.

In an embodiment, the controller turns off the electromagnets or reduces the force of the electromagnet, when the hatch is going to be opened by the air pressure. For example, the controller may turn off the electromagnets before turning on the fans. When the fans are turned off, the controller may turn on the electromagnets again that locks the hatch in the closed position.

Referring to Figure 3A, in an embodiment, the cabinet comprises a shelter 306 placed in the cabinet over the hatch arrangement 100, wherein the shelter 306 is configured to prevent, for example, ingress or water into the cabinet 102 when the hatch 200 is open. The hatch 200 may be placed on the top of the cabinet 102 and, for example, rainwater may then enter into the cabinet 102 when the hatch 200 is open. The shelter 306 may be placed such that the hatch 200 is inside and/or under the shelter 306. In Figure 3A, the hatch arrangement 100 is not placed under the shelter 306 because of illustrative purpose.

Next example describes a function of the hatch arrangement in the cabinet. The airflow outlet hole of the cabinet is covered by the hatch arrangement. The electronic equipment is placed inside the cabinet comprising the fans for providing the cooling airflow. When the fans are not in use, the hatch is in the closed position, wherein the closed position is ensured by the magnetic holding members. The closed hatch is against the sealing member that is placed on the cabinet or collar and the sealing member creates the sealing interface around the airflow hole preventing dust and water ingress into the cabinet. When turning on the fans, the hatch should be opened to blow the airflow of the fans out of the cabinet. Then the rotation speed of the fans is set to the level, wherein the force of the airflow exceeds the holding force of the magnetic holding members and the force of the airflow opens the hatch. In some case, the airflow needed to open the hatch may be greater than the airflow needed for the cooling. Then the rotation speed of the fan is higher for a while to get the hatch open and when the hatch is open, the rotation speed is reduced to the level that is needed for cooling. Turning of the fans closes the hatch because of the gravity and attraction of the magnetic holding members.

The invention provides very easy and effective solution for opening and closing the hatch of the airflow hole in the cabinet just by controlling the airflow of the fans. The invention further provides an effective solution for holding the hatch in the closed position such that the interface between the cabinet and hatch is sealed against dust and moisture.

Fastening members like, for example, screws, rivets, bolts, nuts and/or glue may be used in the hatch arrangement and/or coupling the hatch arrangement with the cabinet. In addition, any other fastening members or combination of different fastening members suitable for coupling the parts together may be used. If the fastening member penetrates the sealing interface, also some sealing member may be used with the fastening members. The sealing member may also be a part of the fastening member.

It will be obvious to a person skilled in the art that, as the technology advances, the inventive concept can be implemented in various ways. The invention and its embodiments are not limited to the examples described above but may vary within the scope of the claims.

## Claims

1. A hatch arrangement for an airflow hole of a cabinet, comprising:
an openable hatch coupled with the cabinet, wherein the hatch is configured to cover the airflow hole in a closed position;
a sealing member configured to be compressed around the airflow hole between the cabinet and the hatch when the hatch is in the closed position; and
one or more magnetic holding members configured to provide a force for holding the hatch in the closed position and ensure a compression of the sealing member between the cabinet and the hatch when the hatch is in the closed position.

2. The arrangement according to claim 1, wherein the arrangement further comprises a collar around the airflow hole, wherein the collar is coupled with the cabinet.

3. The arrangement according to claim 2, wherein the sealing member is coupled with the collar.

4. The arrangement according to any preceding claims, wherein the one or more magnetic holding members comprise a magnet and a magnetic responsive part.

5. The arrangement according to claim 4, wherein the magnet is coupled with the cabinet and/or the collar and the magnetic responsive part is coupled with the hatch.

6. The arrangement according to claim 4, wherein the magnet comprises a permanent magnet.

7. The arrangement according to claim 4, wherein the magnet comprises an electromagnet.

8. The arrangement according to any preceding claims, wherein a shape of the hatch is substantially a rectangular, wherein the one or more magnetic holding members are substantially at each corner area of the hatch in the closed positon of the hatch.

9. The arrangement according to any preceding claims, wherein the sealing member comprises a polymer gasket, wherein the polymer gasket is configured to form a continuous shape around the airflow hole and a sealing interface between the hatch and the cabinet.

10. The arrangement according to claim 9, wherein the sealing interface is configured to prevent at least partly ingress of dust and/or ingress of moisture into the cabinet via the airflow hole when the hatch is in the closed position.

11. The arrangement according to claims 9 - 10, wherein the one or more magnetic holding members are configured to stay inside the sealing interface when the hatch is in the closed position.

12. The arrangement according to any preceding claims, wherein the sealing member is coupled with the cabinet.

13. The arrangement according to any preceding claims, wherein the sealing member is coupled with the hatch.

14. An electronic system, comprising electronic equipment in a cabinet, wherein the cabinet comprises an airflow hole, and wherein the cabinet further comprises a hatch arrangement according to claims 1-13.

15. The system according to claim 14, wherein the electronic equipment in the cabinet comprises one or more fans configured to provide a cooling airflow that is guided through the airflow hole of the cabinet, and
wherein the cooling airflow, provided by the one or more fans, is configured to release holding of the closed hatch, when a force of the cooling airflow exceeds a force of one or more holding members of the hatch arrangement, and open the hatch.
